# EUROPEAN PATENT SPECIFICATION

(11) **EP 1 881 602 B1**
(45) Date of publication and mention of the grant of the patent: **14.08.2019**
(21) Application number: 06117328.2
(22) Date of filing: 17.07.2006
(51) Int. Cl.: H03G 3/34, H03F 3/72, H03F 3/68, H03F 3/187

(54) **Method and circuit for audio output muting**
Verfahren und Schaltung zum Stummschalten eines Audio Ausgangs
Méthode et circuit de mise en sourdine pour sortie audio

(43) Date of publication of application: 23.01.2008
(73) Proprietor: Vestel Elektronik Sanayi ve Ticaret A.S., 45030 Manisa (TR)
(72) Inventor: SARIARSLAN, M.Kursat, 45030, Manisa (TR)
(74) Representative: Beck Greener LLP

(56) References cited:
- EP-A1- 1 139 562
- EP-A1- 1 148 638
- EP-A2- 1 439 732
- DE-A1- 2 601 940
- JP-A- 57 104 310
- US-A- 3 628 058
- US-A- 4 947 454
- US-A- 5 295 178
- US-A- 5 440 643
- US-A1- 2006 103 458

## Description

### Field of the invention

The present invention relates to a method and circuit for audio output muting. In particular, the present invention is concerned with controlling the muting of an audio amplifier so as to avoid the disturbing signal noise which is produced when an audio source has a low signal output level.

### Discussion of the prior art

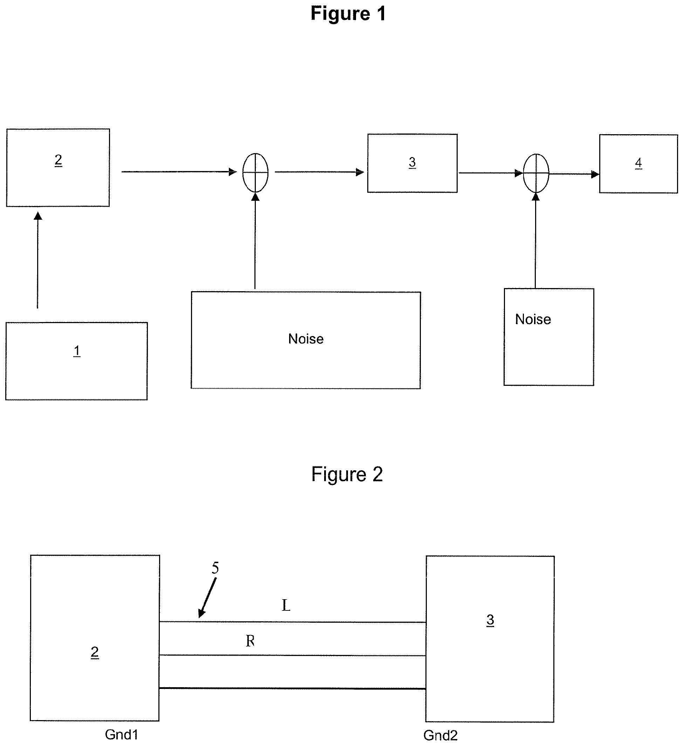

In a standard TV receiver, as shown in Figure 1, an audio signal from a signal source 1, such as a tuner, is processed by an audio processor 2 and is then transferred to an audio amplifier 3, where the audio signal is amplified so that it is audible to a listener, before being output to one or more speakers 4. However, as the audio signal is transferred from the audio processor 2 to the audio amplifier 3, signal noise is produced by the internal circuits of the receiver e.g. power supply circuit, power cables, driver circuits, matrix circuits etc; by the audio amplifier; and by unmatched signal connections. This signal noise accompanies the audio signal on its path through the receiver to the speakers and unwanted small noise signals are amplified by the audio amplifier 3 so that they become intrusive to a listener at low volume levels.

There are many sources of internal signal noise. The current absorbed by each of the circuits in use and the operating frequency of such circuits generate noise on the feed and ground lines. This noise is dependent upon the structure of the circuits and if the ground lines of two different circuits are connected, this can cause the two circuits to affect each other. In many electronic systems, therefore, the ground lines of an analogue operating section and a digital operating section are separated, because with the digital section operating at a particular frequency noise can be generated on both the feed and the ground lines.

Similarly, class D circuits use oscillators which generate noise on the feed and ground lines. This noise might not damage the internal working of the system but it can affect other circuits at lower / different operating frequencies and generate ground line noise. Ground separation is also an important issue in pcb design, because a non-stable ground structure can be affected by the operating frequencies and absorb high currents. The reference ground line should always have a voltage level of 0 which is difficult to maintain where the ground structure is unstable. Where ground impedance is high then the impedance of the circuit ground will go high. For example, if a circuit which operates at 10 KHz has a non-stable ground structure, the noise belonging to the operating frequency will also appear on the ground line. Audio amplifiers , that have high power demands, often encounter this problem. Although, this problem can be addressed by making the ground line wider and by lowering its internal resistance which can reduce the effect of the operating frequency of the circuit on the ground line, this is not always possible due to mechanical limits and the number of lines used in the circuit.

Various steps have been taken to attempt to eliminate noise from audio signals. For example, shielded audio cables have been used to reduce internal system noise by suppressing environmental magnetic noise. But, as shown in Figure 2, at the same time such shielded cables connect the ground lines 5 of the two circuits 2, 3. As a result of a shielded cable being used, these two circuits (audio amplifier 3 and audio source 2) are therefore able to affect each other and, as a result, noise is superimposed on the audio signal.

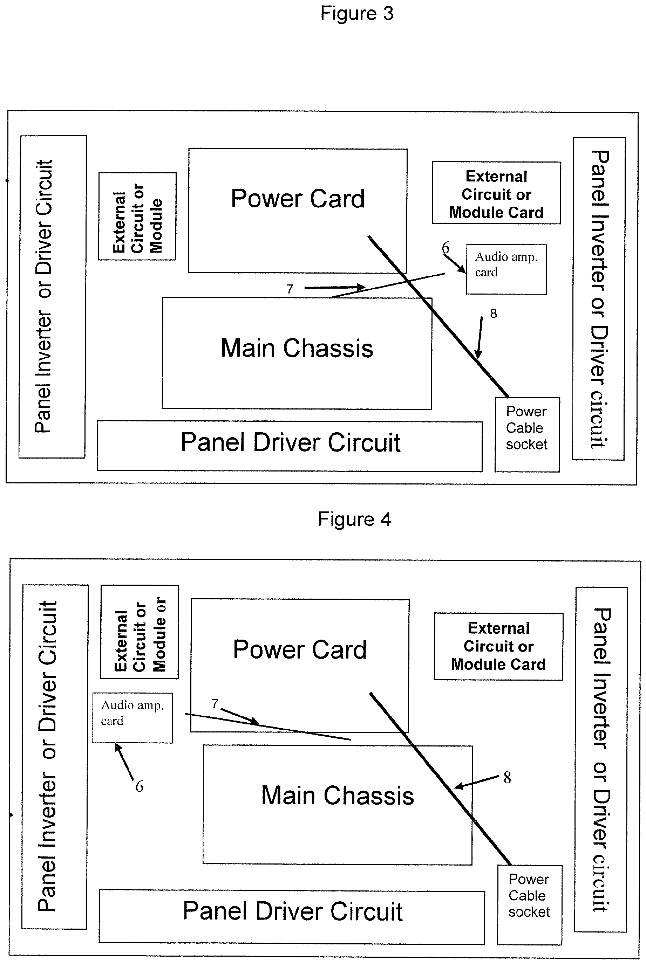

Also, shielded audio cables may included ferrites which are substances whose internal resistances differ according to some particular frequencies. For example they may have 10 Ohm internal resistance at 100 Hz and 250 Ohm internal resistance at 10 MHz. Each ferrite has its own characteristics, but they are not, in general, effective on low frequency signals, like audio signals. Accordingly, using ferrites with audio cables does not eliminate audible noise on an audio signal. They can, though, address the problem that arises as a result of the shielded cables connecting the ground lines of the audio source and audio amplifier circuits, but not always successfully. Another disadvantage of using ferrites is their cost, they are very expensive and at least two pieces are needed for each cable. Also, in vibration and drop tests of the receivers, cables with ferrites do not perform well. Furthermore, the physical positioning of the separate circuits of an electronic sound reproduction system can alter the amount of signal noise that arises internally in the system. For example, in Figure 3 an audio amplifier card 6 is shown positioned so that the audio cable 7 is caused to cross over the main power cable 8. The physical closeness of the two cables will cause additional noise in the audio signal. In Figure 4, on the other hand, with the audio amplifier card 6 in a different position, the audio cable 7 is kept away from the power cable 8 thereby minimising noise effects associated with the power cable. Circuits have also been devised to 'mute' the output of sound reproduction systems especially in circumstances where power to the system is interrupted. For example, in JP 8213849 a signal bypass system provided on the input to the speakers of a sound reproduction system is described which is activated whenever power to the system is interrupted. The signal bypass system is provided in order to avoid the distinctive 'pop' noises that arise from capacitative discharge. Similarly, in EP-A-0757437 a computer system is described in which the power management system of the computer issues a mute signal to the audio amplifier whenever a power-down situation arises, in order to minimise energy consumption.

In JP 11086433 a computer system includes means for muting the speaker outputs whenever computer data, as opposed to audio data, is being read by the computer.

Also JP 6075798 describes a circuit for preventing damage to speakers as a result of abnormal noises. The circuit employs a buffer which enables the audio signals to be sampled prior to being input to the speakers in order to detect any abnormalities in advance. Where abnormalities are detected, the audio output data is then muted.

US2006/103458 discloses a digital audio amplifier system capable of driving four output audio channels comprising an audio PWM processor which itself comprises a controller configured to receive and process a mute signal. The system is directed to reduce click and pop noise occurring during the muting and un-muting of the power amplifiers of the digital audio amplifier system.

EP1139562 discloses an FM radio having a squelch circuit that detects the presence of an RF signal in order to control the muting and un-muting of the audio amplifier. If an RF signal is detected, it carries information (e.g. voice, music, data) and the audio amplifier is un-muted, if no RF signal is detected the audio amplifier is muted.

### Summary of the invention

The present invention seeks at least to reduce and preferably to eliminate, from the speaker output, noise caused by ground lines as well as system interference noise arising for example from the power supply, power cables, driver circuits, matrix circuits, unmatched signal connections and even the audio amplifier itself etc., all of which are amplified by the audio amplifier.

The present invention is based on the realisation that when the volume of a speaker is high and the signal processor feeds the speaker with an audio signal whose voltage level is high enough to be detectable, any noise associated with the audio signal generally does not disturb the listener. However, when the strength of the output signal from the TV (or receiver) is low or, in the case of a TV receiver, the receiver is switched to AV mode, or when a listener watches a programme with a silent scene, the noise can be disturbing for the listener.

The scope of the present invention is defined by the appended independent claim. Preferred embodiments are set out in the dependent claims.

Thus, the principle of the present invention is to detect the existence and the level of a signal at the output of the signal processor. If a signal output from the signal processor is not detected or is below a voltage threshold then the system mutes the output of the audio amplifier. If, on the other hand, a signal exists and its voltage level is high enough, the output of the audio amplifier is not muted.

With the present invention a television receiver is provided which prevents a listener from hearing noise coming from the speakers when the audio sound signal fed from the audio processor is at a low voltage level and audible internal noise is eliminated from the speaker output by muting the speaker input or, specifically, by muting the audio amplifier.

### Brief description of the drawings

Embodiments of the present invention will now be described by way of example, only with reference to the accompanying drawings, in which:
Figure 1 is a block diagram of a conventional TV receiver;
Figure 2 is a block diagram illustrating the use of shielded audio cables;
Figure 3 is a block diagram of a conventional sound reproduction system with the audio amplifier in a first position;
Figure 4 is a block diagram of the sound reproduction system of Figure 3 but with the audio amplifier in a second, alternate position;
Figure 5 is a block diagram of an embodiment of a sound reproduction system in accordance with the present invention;
Figure 6 is a block diagram of an alternate embodiment of a sound reproduction system in accordance with the present invention;
Figure 7 illustrates a circuit diagram of a noise/signal detector for use in the sound reproduction systems of Figures 5 and 6; and
Figure 8 illustrates a circuit diagram of a noise/signal detector having a user controllable threshold circuit for use in the sound reproduction systems of Figures 5 and 6.

### Description of preferred embodiments

The basic idea behind the method is, detecting the voltage level at the output of the sound processor and muting the audio-amp output if there exists a low signal voltage level, which means when the audio signal will not be noticeable by the user.

As it is known that not all noise is related to audio source and to detect all the input noise is not easy, the sound processor output is taken as the main, clear audio source. Investigations have proved that signals below 20 mV coming from the audio processor cannot be easily detected by a listener at a normal volume level. Accordingly, to solve the problem, a "noise, signal detector" circuit is used. This circuits determines whether or not there exists any signal at the output of the audio processor and, if such a signal exists, whether the signal level is below or above the predetermined and adjustable threshold voltage level (10mV-20mV). If a signal above this level does not exist, the circuit gives an output (logic high).

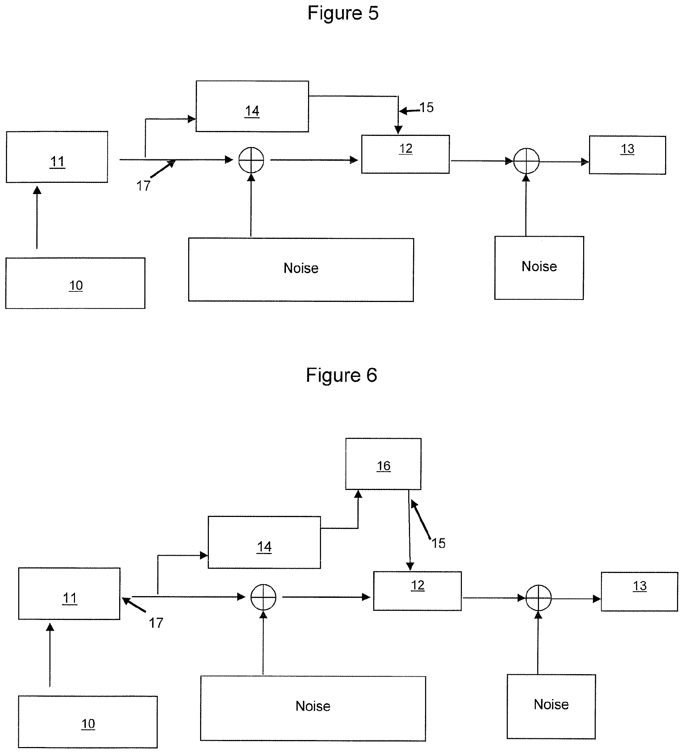

A first embodiment of a sound reproduction system is illustrated in Figure 5 which is suitable for use, for example, as part of a TV receiver. The sound reproduction system comprises an audio signal source 10 such as a tuner, the output of which is in communication with an audio processor 11. The output of the audio processor 11 is in turn in communication with an audio amplifier 12 which is in turn in communication with one or more speakers 13. As shown in Figure 5, noise can be introduced to the audio signal between the audio processor 11 and the audio amplifier 12 and at the amplifier 12. The sound reproduction system further includes a detector 14. The input to the noise-signal detector 14 is in communication with the output of the audio processor 11 and the output of the detector 14, which constitutes a mute control signal 15, is in communication with the audio amplifier 12 and controls the audio amplifier 12 directly.

In the configuration illustrated in Figure 5, the noise-signal detector circuit 14 controls the audio amplifier directly in order to achieve a quick response. However, some undesired noise may still be audible due to the mute circuit (not illustrated) of the audio amplifier 12. A second embodiment of the sound reproduction system is illustrated in Figure 6 and like reference numerals have been used where appropriate. The sound reproduction system of Figure 6 includes a controller in the form of a microprocessor 16 which is used to control the audio amplifier 12. The microprocessor 16 receives the output of the noise-signal detector circuit 14 and controls the audio amplifier. Thus, the output signal from the noise-signal detector 14 is sent to the microcontroller 16 and the microcontroller 16 then determines what to do. The output of the audio amplifier 12 may be muted by the microcontroller 16 for example by reducing the equalizer level, subject to predetermined control settings in the microcontroller 16. In this embodiment of the invention, the muting function is operated by a PWM signal generated by the microcontroller. By changing the pulse width of this PWM signal, a signal with variable dc level is in turn generated. This dc signal is transmitted through a circuit that includes transistors and is applied to the base of another transistor in the mute circuit. The base voltage determines the sensitivity of the transistor to switching control, which in turn makes it operable at the desired noise detection level. A disadvantage of this configuration is, the output from the microcontroller 16 may not be fast enough for the input signal to the audio amplifier 12. Therefore this design is more suited for use in situations in which there is a long silence, for example of 1 sec or more.

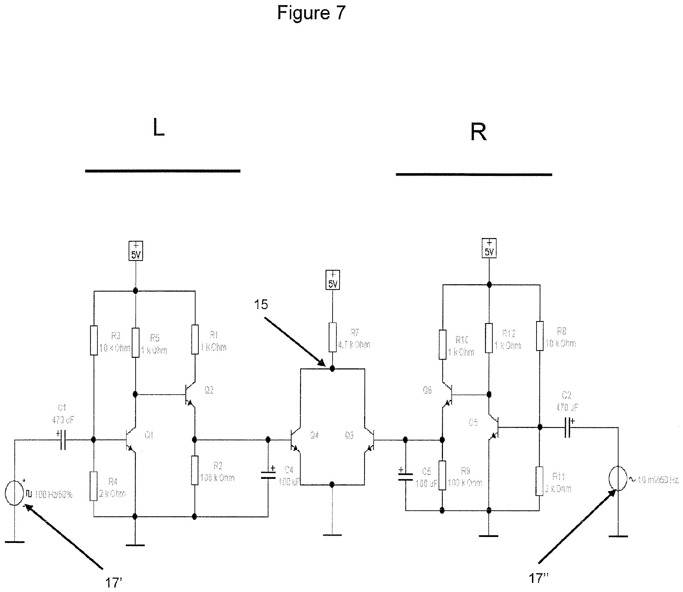

One version of a noise-signal detector circuit 14 suitable for use in the sound reproduction systems of Figures 5 and 6 is illustrated in Figure 7. The noise-signal detector 14 of Figure 7 has two symmetrical detector circuits, one each for left and right audio channels. The respective left and right channel input signals 17' and 17", output from the audio processor 11, are supplied to respective isolating capacitors C1 and C2 which block the DC level of the input signal. The isolating capacitors C1 and C2 also act, in combination with resistors R4 and R11 respectively, as threshold determining circuits or high pass filters where their values determine the input signal frequency (input to the detection circuit). To detect all possible noises, the value of the capacitors is preferably chosen to be high. The outputs of each of the high pass filters is then applied to respective amplifier stages R3, R5 and Q1 and R8, R12 and Q5 with the outputs of the amplifier stages being applied to the bases of the respective emitter follower transistors Q2 and Q6 the gates of which are connected to respective smoothing circuits R2, C4 and R9, C5. The resistors R3, R4 determine the threshold level of transistor Q1 and the resistors R8 and R11 determine the threshold level of transistor Q5. By changing the values of R3 and R4 and similarly R8 and R11, the signal level to be detected can be adjusted. In the configuration illustrated in Figure 7, the resistors are selected to detect signals output from the audio processor 11 down to 10-20mV.

If the level of the input signal 17' for the left channel is lower than 20mV, then transistor Q1 stays in an 'on' state. With transistor Q1 'on', then transistor Q2 goes into an 'off state and logic level 'low' appears at the base of transistor Q4. This, in turn, results in the emitter side of transistor Q4 staying at a 'high' logic level. But to maintain this point, which is the mute control output 15 of the detection circuit, at a 'high' logic level, the other half of the detector circuit (the right channel detector circuit) must also have an input signal 17" lower than 20mV. For this purpose, transistors Q3 and Q4 are arranged to function as an "AND" circuit.

Where peak to peak levels of the input signals 17' (or 17") are higher than the predetermined threshold level (e.g. 20mV), then transistor Q1 swaps between 'on' and 'off' states according to the input waveform because the input signal is AC and so varies around 0V voltage level. Transistor Q1 amplifies the input signal level and drives the base of transistor Q2. As mentioned earlier, transistor Q2 is used as an emitter follower, so that the input signal (the signal at the base of the transistor) appears on both resistor R2 and capacitor C4. The resistor R2 in combination with the capacitor C4 function as a smoothing circuit, converting the varying DC levels to an approximately level DC voltage. At the base of transistor Q4 a logic 'high' DC level appears and transistor Q4 becomes active which results in the emitter side of transistor Q4 going into a 'low' state. Even if there is no signal in the right channel, the voltage level at the output 15 of the detection circuit does not change. Thus, it will be appreciated that transistors Q3 and Q4 function as switches.

Thus, with the detector 14 illustrated in Figure 7, a logic 'high' state at the output 15 of the detector functions as a mute control signal 15 indicating that the audio amplifier 12 should be muted. On the other hand, a logic 'low' state at the output 15 of the detector indicates that the audio amplifier 12 should be active amplifying the audio signals 17 it receives from the audio processor 11.

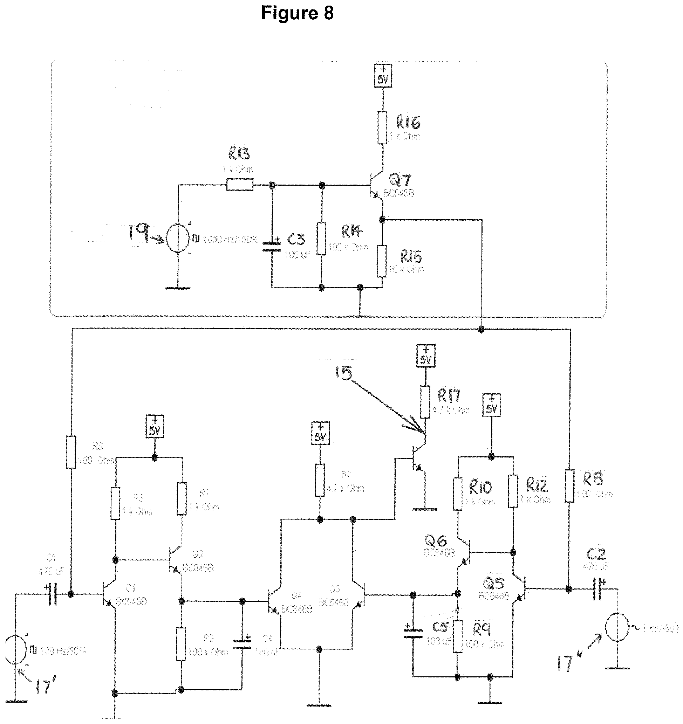

In another embodiment of the noise signal detector illustrated in Figure 8, the listener is provided with the means to adjust the threshold level of the noise detection circuit. Conveniently, the threshold adjusting means may be implemented in a user operated remote controller programmed for adjusting not only the voltage threshold for triggering muting of the audio amplifier but other functions of the TV or receiver such as the audio amplifier volume volume or channel. A controllable voltage source is needed in order to provide the listener with control over the threshold (noise detection) level of the detection circuit. The PWM ports on a microcontroller IC can be used for this purpose. If the microcontroller doesn't have PWM ports, a separate PWM circuit can be used. As seen from the circuit, this PWM output 19 can be connected to capacitor C3, resistor R14 and transistor Q7 components through the resistor R13. The PWM signal 19 has a constant frequency and a variable duty cycle (ac component) and the RMS value of the signal varies as well, as the duty cycle varies (dc component). R13, C3 and R14 (low pass filter) components are used to derive the dc component of the signal. Thus, a dc signal (not an ac signal) exists at the base input of the transistor Q7. The dc level of this signal will vary according to the change of the duty cycle of the input signal 19. This derived dc voltage is then transferred to the other circuit block through the transistor Q7, which means that transistor Q7 acts as a buffer in this circuit.

The transferred signal is applied to the base of transistors Q1 and Q5 located at the pre-amplification section of the noise detection circuit. The voltage level of the signal is sufficient to switch on the transistors. If the applied dc level is low, the transistors are less responsive and switch on with more difficulty in response to the input signal 17'. On the other hand, the higher the applied dc level, the higher the effect of the signal noise on the transistors to switch on. Thus, the sensitivity of the noise detection circuit to noise can be adjusted by the dc voltage coming from the (first) listener adjustable circuit.

The listener can adjust the threshold of the circuit by means of an item that can be placed on the menu of the microcontroller and thus can decide which signals are noise and which ones are normal audio signals.

With the sound reproduction systems described herein a simple and effective way of eliminating undesirable noise from the speaker outputs is provided which does not require digital circuitry and offers the opportunity, in a simple and effective manner, for either the circuit designers or for listeners to adjust the threshold levels of the detector so as to selectively discriminate between audio signals and noise.

It will, of course, be appreciated that the present invention is not limited to the specific embodiments described herein and instead is only limited by the accompanying claims. For example, the microcontroller is only an optional feature and the particular sizes of the electrical components are illustrative only. Also, although reference has been made herein to a pair of audio channels it will be apparent that the invention applies sets of audio channels in excess of two. Preferably, the transistors, and in particular transistors Q1 and Q5, are bipolar transistors.

## Claims

1. A television receiver comprising a sound reproduction system comprising: an audio processor (11); a plurality of separate audio channels; an audio amplifier (12) connected to an output of the audio processor (11) through the plurality of separate audio channels; one or more speakers (13), the one or more speakers (13) being in communication with an output of the audio amplifier (12); and, an audio signal detector (14) in communication with the output of the audio processor (11), wherein the audio signal detector (14) is adapted to monitor a signal strength between the audio processor (11) and the audio amplifier (12) of an output signal from the audio processor (11) and adapted to generate a mute control signal in response to which the output of the audio amplifier (12) is muted, the sound reproduction system being **characterised in that** the audio signal detector (14) comprises for each audio channel: a detector circuit and a threshold determining circuit (R3, R4, R8, R11) having an output connected to an input of the detector circuit and configured to determine at said output of the threshold determining circuit a threshold voltage of said detector circuit at which the mute control signal is generated wherein the threshold determining circuit comprises an isolating capacitor (C1, C2) by means of which it is coupled to the output of the audio processor, and wherein each detector circuit comprises an amplifier stage (Q1, R5, Q5, R12) having an input connected to the output of the threshold determining circuit, an emitter follower (Q2,Q6) having an input connected to an output of the amplifier stage (Q1, R5, Q5, R12), a smoothing circuit (R2, C4, R9, C5) having an input connected to an output of the emitter follower (Q2,Q6) and a transistor functioning as a switch (Q3,Q4) and having a base connected to an output of the smoothing circuit, wherein the switches (Q3,Q4) of the detector circuits of the plurality of separate audio channels are arranged to function as an AND circuit so that the mute control signal is generated only when the output signal strength from the audio processor for each audio channel of the plurality of separate audio channels is below the threshold voltage.

2. A television receiver as claimed in claim 1, the sound reproduction system further comprising a controller (16) coupled to the audio signal detector (14) and configured to mute the output of the audio amplifier (12) in response to the mute control signal.

3. A television receiver as claimed in either of claims 1 or 2, the sound reproduction system further comprising a threshold adjustment means (R13, C3,R14,R15,Q7,R16) configured to adjust the threshold voltage.

4. A television receiver as claimed in claim 3, the sound reproduction system further comprising a remote controller programmed to permit remote adjustment by a user of the threshold voltage.

## Patentansprüche

1. Fernsehempfänger, umfassend ein Tonwiedergabesystem, das umfasst: einen Audioprozessor (11); eine Vielzahl von separaten Audiokanälen; einen Audioverstärker (12), der über die Vielzahl von separaten Audiokanälen mit einem Ausgang des Audioprozessors (11) verbunden ist; einen oder mehrere Lautsprecher (13), wobei der eine oder die mehreren Lautsprecher (13) mit einem Ausgang des Audioverstärkers in Verbindung steht; und einen Audiosignaldetektor (14) in Verbindung mit dem Ausgang des Audioprozessors (11), wobei der Audiosignaldetektor (14) dazu angepasst ist, eine Signalstärke zwischen dem Audioprozessor (11) und dem Audioverstärker (12) eines Ausgangssignals aus dem Audioprozessor (11) zu überwachen und dazu angepasst ist, ein Stummschaltungssteuersignal zu erzeugen, in Reaktion auf das der Ausgang des Audioverstärkers (12) stummgeschaltet wird, wobei das Tonwiedergabesystem **dadurch gekennzeichnet ist, dass** der Audiosignaldetektor (14) für jeden Audiokanal umfasst:
eine Detektorschaltung und eine Schwellenwertbestimmungsschaltung (R3, R4, R8, R11) mit einem Ausgang, der mit einem Eingang der Detektorschaltung verbunden und dazu ausgelegt ist, an dem Ausgang der Schwellenwertbestimmungsschaltung eine Schwellenspannung der Detektorschaltung zu bestimmen, an der das Stummschaltungssteuersignal erzeugt wird, wobei die Schwellenwertbestimmungsschaltung einen Trennkondensator (C1, C2) umfasst, durch den sie mit dem Ausgang des Audioprozessors gekoppelt ist,
und wobei jede Detektorschaltung eine Verstärkerstufe (Q1, R5, Q5, R12) umfasst, die einen Eingang aufweist, der mit dem Ausgang der Schwellenwertbestimmungsschaltung verbunden ist, einen Emitterfolger (Q2, Q6), der einen Eingang aufweist, der mit einem Ausgang der Verstärkerstufe (Q1, R5, Q5, R12) verbunden ist, eine Glättungsschaltung (R2, C4, R9, C5), die einen Eingang aufweist, der mit einem Ausgang des Emitterfolgers (Q2, Q6) verbunden ist, und einen Transistor, der als ein Schalter (Q3, Q4) fungiert und eine Basis aufweist, die mit einem Ausgang der Glättungsschaltung verbunden ist, wobei die Schalter (Q3, Q4) der Detektorschaltungen der Vielzahl von separaten Audiokanälen dazu angeordnet ist, als eine UND-Schaltung zu fungieren, sodass das Stummschaltungssteuersignal nur erzeugt wird, wenn die Stärke des Ausgangssignals aus dem Audioprozessor für jeden Audiokanal der Vielzahl von separaten Audiokanälen unterhalb der Schwellenspannung liegt.

2. Fernsehempfänger nach Anspruch 1, wobei das Tonwiedergabesystem ferner eine Steuerung (16) umfasst, die mit dem Audiosignaldetektor (14) gekoppelt und dazu ausgelegt ist, den Ausgang des Audioverstärkers (12) in Reaktion auf das Stummschaltungssteuersignal stummzuschalten.

3. Fernsehempfänger nach entweder Anspruch 1 oder 2, wobei das Tonwiedergabesystem ferner ein Schwellenwerteinstellmittel (R13, C3, R14, R15, Q7, R16) umfasst, das dazu ausgelegt ist, die Schwellenspannung einzustellen.

4. Fernsehempfänger nach Anspruch 3, wobei das Tonwiedergabesystem ferner eine Fernsteuerung umfasst, die dazu programmiert ist, eine Ferneinstellung der Schwellenspannung durch einen Anwender zu erlauben.

## Revendications

1. Récepteur de télévision comprenant un système de reproduction de son comprenant : un processeur audio (11) ; une pluralité de canaux audio séparés ; un amplificateur audio (12) connecté à une sortie du processeur audio (11) par l'intermédiaire de la pluralité de canaux audio séparés ; un ou plusieurs haut-parleurs (13), le ou les haut-parleurs (13) étant en communication avec une sortie de l'amplificateur audio (12) ; et un détecteur de signal audio (14) en communication avec la sortie du processeur audio (11), le détecteur de signal audio (14) étant conçu pour surveiller une intensité de signal entre le processeur audio (11) et l'amplificateur audio (12) d'un signal de sortie en provenance du processeur audio (11) et conçu pour générer un signal de commande de mise en sourdine en réponse auquel la sortie de l'amplificateur audio (12) est mise en sourdine, le système de reproduction de son étant **caractérisé par le fait que** le détecteur de signal audio (14) comprend pour chaque canal audio : un circuit de détection et un circuit de détermination de seuil (R3, R4, R8, R11) ayant une sortie connectée à une entrée du circuit de détection et configuré pour déterminer, au niveau de ladite sortie du circuit de détermination de seuil, une tension de seuil dudit circuit de détection à laquelle le signal de commande de mise en sourdine est généré, le circuit de détermination de seuil comprenant un condensateur d'isolation (C1, C2) au moyen duquel il est couplé à la sortie du processeur audio, et chaque circuit de détection comprenant un étage d'amplificateur (Q1, R5, Q5, R12) ayant une entrée connectée à la sortie du circuit de détermination de seuil, un émettodyne (Q2, Q6) ayant une entrée connectée à une sortie de l'étage d'amplificateur (Q1, R5, Q5, R12), un circuit de lissage (R2, C4, R9, C5) ayant une entrée connectée à une sortie de l'émettodyne (Q2, Q6), et un transistor fonctionnant comme un commutateur (Q3, Q4) et ayant une base connectée à une sortie du circuit de lissage, les commutateurs (Q3, Q4) des circuits de détection de la pluralité de canaux audio séparés étant conçus pour fonctionner comme un circuit ET de telle sorte que le signal de commande de mise en sourdine est généré uniquement lorsque l'intensité de signal de sortie en provenance du processeur audio pour chaque canal audio de la pluralité de canaux audio séparés est au-dessous de la tension de seuil.

2. Récepteur de télévision tel que revendiqué à la revendication 1, dans lequel le système de reproduction de son comprend en outre un dispositif de commande (16) couplé au détecteur de signal audio (14) et configuré pour mettre en sourdine la sortie de l'amplificateur audio (12) en réponse au signal de commande de mise en sourdine.

3. Récepteur de télévision tel que revendiqué à l'une ou l'autre des revendications 1 et 2, dans lequel le système de reproduction de son comprend en outre un moyen d'ajustement de seuil (R13, C3, R14, R15, Q7, R16) configuré pour ajuster la tension de seuil.

4. Récepteur de télévision tel que revendiqué à la revendication 3, dans lequel le système de reproduction de son comprend en outre une télécommande programmée pour permettre un ajustement à distance par un utilisateur de la tension de seuil.
